Europäisches Patentamt

European Patent Office

Office européen des brevets

(11) Publication number: **0 465 733 A1**

# EUROPEAN PATENT APPLICATION

(21) Application number: **90201911.6**

(51) Int. Cl.5: **C23C 14/32**

(22) Date of filing: **13.07.90**

| | |
|---|---|
| The title of the invention has been amended (Guidelines for Examination in the EPO, A-III, 7.3). | **TECNOLOGIE DEL VUOTO**<br>**Via Turanense, Km. 44,452**<br>**I-67061 Carsoli (L'Aquila)(IT)** |
| (43) Date of publication of application:<br>**15.01.92 Bulletin 92/03** | (72) Inventor: **Misiano, Carlo**<br>**V. G.B. Morgagni, 22**<br>**I-00161 Roma(IT)**<br>Inventor: **Simonetti, Enrico**<br>**Viale Marconi, 112**<br>**I-00146 Roma(IT)** |
| (84) Designated Contracting States:<br>**CH DE FR GB LI NL SE** | |
| (71) Applicant: **CONSORZIO CE.TE.V. CENTRO** | |

(54) **Vacuum ion plating method for the deposition of thin layers.**

(57) The vacuum ion-plating method for the deposition of thin layers, operates as follows:

The substrates on which the thin layers are to be deposited are exposed in a vacuum chamber to a plasma condensed by a magnetic field. The substrates are thus negatively polarized and a percentage of the material to be deposited is ionized after vaporization from an appropriate source.

The invention may be placed in the technical field for the deposition of thin layers.

The above invention finds some advantageous applications in the industrial field concerning the processing and treatment of metal, glass, resins and other's and generally in the electronic and optical field, etc, etc, for civilian and military uses, wherever there is a requirement for vacuum deposition of thin layers.

## METHOD, ION PLATING VACUUUM TYPE FOR THE DEPOSITION OF THIN LAYERS.

The invention is concerning a method of ion plating vacuum type for the deposition of thin layers.

It must be placed for its best utilization, in a production laboratory, in the research department, and wherever there is exigences for the vacuum deposition of thin layers on metallic and dielectric materials, semiconductors, or other's.

The invention places itself in the technical field for the deposition of thin layers, finding application in the electronics and optical fields too; moreover it has advantageous applications for the treatment of plates for the aviation and for the civilian fields, example:
- decoration sector;
- building sector (glass) etc;
- automobile sector;
- for the metallurgic sector in general.

In the past time this type of ion plating technique has been realized using a plasma in direct current or R.F. (Radio-Frequency) eventually supported with a thermionic emission of electrons. Such process, aforesaid, had some limits, example:

A) to need a raised power to the cathodic polarization structure for a sufficient ionization of the depositing material often causing an excessive heating of the substrates;

B) it is scarcely adaptable to the continuous processes;

C) it endures, and not seldom, an excessive tension of self-polarization of the substrate, a thing well known, that in many cases worsen the compactedness of the deposited layer.

It was necessary, to obviate the inconvenients above described, to realize a process with a magnetic field to permit a density and localiza tion of the plasma, its task being to supply the Polarization to the substrate, to ionize a part of the depositing molecules vaporized by the source and supply too the gaseous ions reactive or not reactive, with the bombardment of the substrate before and during the growth of the thin layer. with the proceeding, concerning the subject of the presented invention, we obtain the wanted results because the plasma thickened and relegated to the magnetic field presents a greater probability of ionization of the depositing material, because the electrons have got at those energies a section of impact more heightened towards the vaporized particles, and the vaporization tension of the substrate results more lower, caused by the of the plasma, placing itself in an optimal band for dielectric and metallic materials.

An other advantage, presented by the proposed solution, it is the one that permits to be prof itably coupled as source of the vaporized materi al, with sputtering source type magnetron linears, constituting together, a structure very adaptable for continuous processes for the substrates too of great dimensions, as glasses for the building, metal plates, plastic films, papery supports.

With this particular configuration we obtain an optimum checkprocesses, thank to the easiness with which we check the deposition speedness and the polarization of the substrate.

The invention permits the realization of plants for the continuous deposition or in line, of increasing productivity compared to the existing ion plating plants.

To realize the cathodic structure necessary for this method, we may utilize too for simplicity a structure type magnetron sputtering either in direct current than Radio-Frequency.

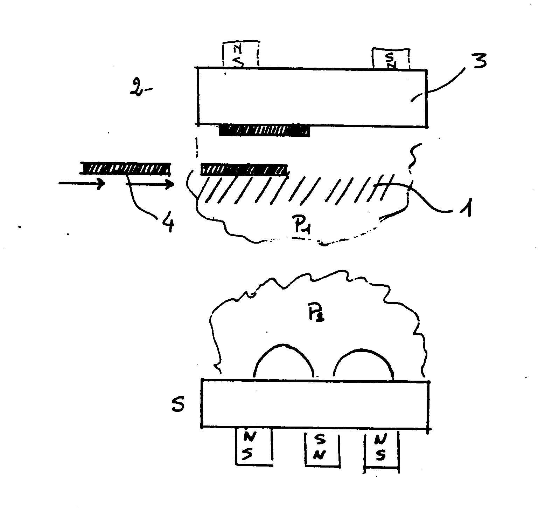

The invention is now described for an illustrative purpose and not restricted, referring to the drawing desk herewith enclosed in which are visible:

1 Zone with magnetic field to densify and confine the plasma P1.

2 Substrate fastened to the cathode 3.

3 Cathode.

4 Substrate in motion facing the cathode.

5 Source of the vaporized material (in the example sputtering magnetron source).

For illustrative purpose and not restricted, it is now described the process, in the configuration actually preferred by the inventors, citing either the case in which the piece to be treated it is fastened on the surface of the polarization cathode or the case in which the piece to be treated it is in motion.

For the first case, the piece to be treated it is fastened with clips, screws or other's to the cathode; then the chamber is evacuated, the gas discharge is connected and consequently the cathode is fed.

In this way the cleaning process of the substrate to be treated starts.

After a suitable time, the evaporation of the material to be deposited, begins and this operation ends when the thickness shall achieve the effective value.

For the second case, once the process parameters are defined, as:
- sliding speedness of the piece;
- evaporation speedness of the material to be deposited;
- substrate temperature;
- discharge gas pressure

- self-bias voltage;
- etc, etc.
let slide with a suitable dragging system, the substrate between two electrodes, and as soon as achieved the effective thickness, an other sub strate repeats the operation and so on.

This invention permits improvement of the thin layers deposition technique, and the working times reduction too, above all in case which would be utilized the dragging aforesaid system between two electrodes.

## Claims

1) Method, "Ion Plating Type" for the vacuum deposition of thin layers, characterized by the fact of utilising a magnetic field to obtain the density of the plasma, that polarizes the substrates and ionizes a part of the condensing material.

2) Method, "Ion Plating Type" for the vacuum deposition of thin layers, as by the first claim, characterized by the fact to have the following configuration: a cathodic structure in direct current or R.F. (Radio-Frequency) supported by a magnetic field generated with permanent magnets or by electromagnets, on which are fastened, or faced to it can slide the substrates to be treated.

3) Method, "Ion Plating Type" for the vacuum deposition of thin layers, as by the first and second claim, characterized by the fact to permit the continuous processes realization of substrates in movement.

4) Method, "Ion Plating Type" for the vacuum deposition of thin layers, as by the first, the second and third claim, characterized by the fact to be applied in various civilian uses, for the building, the handicraft, the aviation, and wherever there is any exigency concerning the deposition of thin layers on suitable vacuum materials.

2-

N
S

S
N

3

IIIIIIIIII

IIIIIIIIII

IIIIIIIIII

4

1

P₁

P₂

S

N
S

S
N

N
S

European
Patent Office

EUROPEAN SEARCH
REPORT

Application Number

EP 90 20 1911

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | LE VIDE, LES COUCHES MINCES, vol. 44, no. 248, August-October 1989, pages 389-399; C. MISIANO et al.: "Dual magnetron ion plating" <br> * Entire article * <br> – – – | 1-4 | C 23 C 14/32 |
| X | EP-A-0 275 021  (HITACHI) <br> * Claims 1,5; figures 1,10 * <br> – – – – – | 1,2,4 | |

TECHNICAL FIELDS
SEARCHED (Int. Cl.5)

C 23 C

The present search report has been drawn up for all claims

| Place of search | Date of completion of search | Examiner |
|---|---|---|
| The Hague | 07 March 91 | PATTERSON A.M. |

CATEGORY OF CITED DOCUMENTS

X : particularly relevant if taken alone
Y : particularly relevant if combined with another
    document of the same catagory
A : technological background
O : non-written disclosure
P : intermediate document
T : theory or principle underlying the invention

E : earlier patent document, but published on, or after
    the filing date
D : document cited in the application
L : document cited for other reasons

& : member of the same patent family, corresponding
    document